(19)

**Europäisches Patentamt**
**European Patent Office**
**Office européen des brevets**

(11) **EP 1 414 078 B1**

(12) **EUROPEAN PATENT SPECIFICATION**

(45) Date of publication and mention
of the grant of the patent:
**08.04.2009 Bulletin 2009/15**

(51) Int Cl.:
**H01L 29/00** *(2006.01)* **H01L 29/06** *(2006.01)*

(21) Application number: **02750851.4**

(22) Date of filing: **01.07.2002**

(86) International application number:
**PCT/EA2002/000006**

(87) International publication number:
**WO 2003/003466 (09.01.2003 Gazette 2003/02)**

(54) **USING AN ELECTRONIC DEVICE AS A QUANTUM SUPERCAPACITOR**

VERWENDUNG EINES ELKTRONISCHEN BAUELEMENTS ALS
QUANTENSUPERKONDENSATOR

UTILISATION D'UN DISPOSITIF ELECTRONIQUE COMME SUPERCONDENSATEUR QUANTIQUE

(84) Designated Contracting States:
**AT BE BG CH CY CZ DE DK EE ES FI FR GB GR
IE IT LI LU MC NL PT SE SK TR**

(30) Priority: **29.06.2001 EA 200100846**

(43) Date of publication of application:
**28.04.2004 Bulletin 2004/18**

(73) Proprietor: **Ilyanok, Alexander Mikhailovich
Minsk, 220007 (BY)**

(72) Inventor: **Ilyanok, Alexander Mikhailovich
Minsk, 220007 (BY)**

(74) Representative: **Hano, Christian et al
v. Füner Ebbinghaus Finck Hano
Mariahilfplatz 2 & 3
81541 München (DE)**

(56) References cited:
**WO-A-00/41245          WO-A-00/41247
WO-A-98/50958          WO-A1-00/41245
WO-A2-00/41247          RU-A- 98 106 151**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

*Field of the invention*

The present invention relates to using of an electronic device according to the preamble of claim 1. More specifically the invention relates to the field of electronics and electrotechnology and can be used in production of capacitors for creation of elements (cells) of memory for integrated microcircuits, in high-Q contours, in decoupling elements and in reserve power supplies. Besides they can be used as sources of a current for a mobile communication facility, in energy installation of electric vehicle, and also for buffer accumulation of electrical energy with high specific density about 1 - 1 ,5 MJ/kg

*Background of the invention*

The electrical capacitors having large specific capacity on the basis of solid dielectrics are known. For example capacitor on $BaTiO_3$ dielectrics have a large permittivity $\varepsilon > 1000$ and specific capacity about 0,3 $F/cm^3$. However in the majority of the power applications of such specific capacity it is not enough. To increase specific capacity different methods are applied. The most effective methods are a nanostructuring of dielectrics such as $BaTiO^3$ by creation of nanosized clusters with shell [1], or creation of thin nanosize films with metallic doping [2]. With the help of such approach, it was possible to increase permittivity up to $\varepsilon=10^5$-$10^6$ and to achieve specific capacity 100-1000 $F/cm^3$. As a result, it was possible to receive specific energy, stored in the capacitor of $2\div20$ MJ/kg. The specific energy stored in such capacitors considerably exceeds specific energy, stored in lead (0.08 MJ/kg) and nickel (0.15 MJ/kg) electrochemical accumulators and is commensurable with specific energy, stored in best lithium accumulators (0.5 MJ/kg) [3]. Obviously, the advantage of capacitors in front of electrochemical accumulators consists in a fast opportunity of accumulation of energy and unlimited quantity of the recharging cycles. However, in capacitors made on the foregoing patents barium titanate is used with a high degree of metal doping. It results in transformation of dielectric to semiconductor. In result, there is a large leakage current, that results in fast loss of the saved energy. Hence, to apply such capacitors for a long-term storage of energy it is not effective. Besides, at the stored energy of more than 2 MJ/kg the film of $BaTiO^3$ is cracking. Thus, it is impossible to achieve a limiting value of 20 MJ/kg practically for a while yet. There are known other type of capacitors with high specific capacity. They are so-called supercapacitors having a double electrical layer, formed between liquid electrolyte and electrode. To increase specific capacity the electrodes are made from various materials with a large specific surface, see for example [4], or the patent [5]. Specific capacity of such capacitors is 2-46 $F/cm^3$ at the maximal specific energy, stored by them up to 0.045 MJ/kg. The limiting stored energy in such capacitors is determined by potential electrolyte dissociation, which does not exceed 2-3 V. Such capacitors are quickly charged and have unlimited recharging cycle. However used electrolyte makes it unreliable, and also increase the leakage current, that reduces an energy storage time. Besides, the low specific reserved energy does not allow replacing by them electrochemical accumulators in practically important cases.
In the listed above solid-state and liquid accumulators the mechanism of transfer of ions is used. For example, in $BaTiO^3$ ions are moved together relatively to a crystal lattice, and in liquid electrolyte the transfer of ions is carried out due to mechanical moving of ions relatively to a surface of electrodes. Such process of movement of heavy ions limits the high-speed characteristics. Therefore, such capacitors cannot be applied in elements of memory of the super high speed integrated circuits.

*Summary of the Invention*

The essence of the invention is the improvement of the power characteristics of capacitors, their operating speed, creation of the capacitor having small leakage current and long storage time of a charge, and also unlimited number of recharging cycles.
The solution of these tasks is possible by transition from a storage of a charge as ions to a storage of a charge as electrons. However, known dielectrics, using the effect of displacement of electrons relatively ions, have $\varepsilon\leq100$. In essence, in all solid-state dielectrics the accumulation of energy occurs due to doing of work on turn of a vector of polarization in unit of dielectric volume electronic or ionic type. Thus, as the much as possible reserved specific energy is determined from the known equation

$$W_e = \frac{1}{2}\varepsilon\varepsilon_0 E^2 = \frac{U^2 C}{2} = \frac{qU}{2} \quad , \qquad\qquad\qquad (1)$$

where $\varepsilon_0$ - vacuum permittivity, $E$ - electric intensity in the capacitor, $U$ - voltage in the capacitor, $C$ - capacity of the capacitor, $q$ - charge on the capacitor. As shown from (1), it is possible to increase specific energy by two ways: or increasing $\varepsilon$, or, that is more effective, increasing $E$. However increasing of intensity of a field $E$ results in irreversible disruption of dielectric [6]. Disruption in solid dielectrics occurs due to electron emission to dielectric from capacitor plates. Emitting in dielectric electrons, under action of an accelerating electrical field, move from the cathode to the anode. On the way they have multitudinous impacts, that results to formation of an electron avalanche, i.e., disruption. As a result of ionization by collision the positive ions are created. They remain in a trace of an avalanches and form a positive charge. Besides, there is an opportunity of activization of electrons taking place in a material of dielectric, which also participate in avalanche disruption. Furthermore at increased dielectric thickness there is a so-called bulk effect, i.e., disruptive voltage of dielectric is reduced steeply, that results in reduction of accumulated specific energy. The avalanche disruption results in destruction of a material of dielectric and formation of a defective channel, which is not restored. In result, the capacitor fails.

Now there are many theories of the mechanism dielectric disruption [6]. But all of them only by approximate ways solve only separate partial tasks.

**The essence of the invention** consists in creation of the new mechanism of accumulation of energy in all volume solid dielectrics due to management of the disruption mechanism and regeneration of working parameters of a material of dielectric.

In the offered invention for simultaneous increase $\varepsilon$ and $E$ it is offered to use the new mechanism of electron movement in dielectric and semiconductors in view of spatial structure of a electron wave, published in the PCT Application [7].

In this work it is shown, that the electron form - its charging wave, changes depending on speed of electron movement and structure of a material, in which it goes. In the simplest cases, the electron form can be presented as charged tore, rotating about the axis. It is possible to present an electron in a minimum of the energy as thin uniformly charged ring with a charge $e$, rotating about the axis with speed $\alpha^2 c$, where $\alpha$ - constant of thin structure, and $c$ - speed of light. The electrostatic field of such electron is concentrated in its plane, i.e., it represents the transverse charged wave. In result, the section of interaction between such electrons is minimal. It is possible to observe such electron state at its movement in vacuum with the speed relatively to the laboratory system of coordinates, less than $\alpha^2 c$ or at its movement in superconductors [7]. The diameter of such electron is determined from experiment of electron "tunneling" through a vacuum interval. It is experimentally established, that the tunnel effect disappears at distance between electrodes about 8 nm [8, chapter 9.4], [9, chapter 3]. This extremely important experimental fact is constantly ignored.

Let's consider, that radius of such ring electron is connected with the world constants [7]:

$$r_0 = \hbar/(m_e\alpha^2 c) = 7,2517 \text{ нм.} \qquad (2)$$

The proposed theoretical model of a ring electron allows a new approach in describing most of time-varying and non-linear processes occurring in condensed matter from new position.

In certain materials it is possible to induce a condition of formation of a ring electron by means of an external action and/or by nanostructuring of a matter. It forms the resonance conditions for operating quantum supercapacitors, which conditions allow their functioning at room and higher temperatures.

Due to reduction of interaction cross-section with ions of a dielectric crystal lattice it is possible to increase working temperature of quantum supercapacitor up to size

$$T_e = m_e\alpha^3 c^2/2k = 1151.86K \quad (878.71^0 C). \qquad (3)$$

The transition potential of electron through a barrier $U_e$=0.09928B corresponds this temperature. At coupling of electrons with the unidirectional spins, their energy grows twice etc.

If electrons with oppositely directed spins couple, the bonding strength, due to the spin turning in space on $\pi$, decreases up to size

$$T_\pi = T_e/\pi = 366.65K \quad (93.5^0 C). \qquad (4)$$

Temperatures $T_e$ and $T_\pi$ are critical working temperatures depending on the given mode of operations of quantum supercapacitors.

The frequency of rotation of an electronic ring will determine limiting working frequency of quantum supercapacitors

$$f_e = \alpha^2 c / 2\pi r_0 = m_e (\alpha^2 c)^2 / h = 3.5037 \cdot 10^{11} Hz \qquad (5)$$

Extreme achievable density of a current in quantum supercapacitor

$$j_e = e f_e / \pi r_0^2 = 4\pi e m_e^3 \alpha^8 c^4 / h^3 = 3.4 \cdot 10^4 A / cm^2 \qquad (6)$$

Maximum allowed field strength, at which disruption begins to occur in quantum supercapacitor

$$E_e = U_e / r_0 = m_e^2 \alpha^5 c^3 / 2e\hbar = 1.37 \cdot 10^5 V / cm \qquad (7)$$

The resistance of a material will determine leakage current of the capacitor, i.e. storage time of energy. The resistance can be calculated on one cluster as follows

$$R_e = h / 2e^2 \alpha = 1.768 \cdot 10^6 \Omega \qquad (8)$$

At series connection of such clusters the resistance grows in a direct proportion and in essence has not an effect for a leakage currents of the capacitor, if the intensity of a field is less $E_e$ and working temperature below $T_e$.

To calculate a power parameters of the capacitor we shall consider, that clusters are centrally symmetrical and together with tunneling transparent shell have a diameter $2.175 \cdot 10^{-6}$ cm. On 1 $cm^2$ will settle down $2.1 \cdot 10^{11}$ such clusters. The steadiest state of cluster will be in a case, when in it there are two electrons. Then 1 $cm^3$ of a material can storage the charge of $2.42 \cdot 10^{-2}$ C. If a working voltage on capacitor plates is $1.37 \cdot 10^5$ V, in compliance with the formula (1) we have the specific reserved energy in the capacitor $W_e = 1.66 \cdot 10^3$ $J/cm^3$. If to use hollow sphere, the specific density of a material at any material will not exceed 1 $g/cm^3$. Hence, the specific energy reserved in 1 kg of a material will make not less than 1.66 MJ/kg. This value corresponds $\varepsilon = 2 \cdot 10^6$.

On the basis of this model began possible to develop an absolutely new principle of work and ways of functioning of capacitors with a solid dielectric according to the given below formula and description of the invention. In principle it is possible to create any defect in a solid material, which will be a certain resonator for a ring wave with radius - $r_0$ and effective capacitor Q - $1/\alpha$. The high capacitor Q of the resonator determines high working temperature of the capacitor.

The essence of the invention is as follows.

In accordance with the present invention a quantum supercapacitor contains at least two electrodes, the interval between which is filled by nanostructured materials, consisting of a plurality of clusters being made in the form of cavities each having a sheath being made as a tunnel-transparent layer, wherein the clusters contact at least in two points of a cavity with next clusters. Then they form the material similar to foam with open pores. The sheath are made from either semiconductor, or dielectric, or high molecular organic substance, and pores are filled either with a gas, or with a semiconductor, or with a dielectric, with properties differing from properties of material of the sheath.

The mode operation of the quantum supercapacitor is **characterized in that** the enclosed electrical field in a working range of strength for work of the capacitor in a mode of a storage should not exceed $1,37 \cdot 10^5$ V/cm. It is determined from a condition $E \leq 2E_{max}$, where $E_{max} = m_e^2 \alpha^5 c^3 / 2e\hbar = 1.37 \cdot 10^5$ B/CM , and the intensity of a field in a mode of a charge should not exceed $4.11 \cdot 10^5$ V/cm, accordingly from a condition $E \leq 3E_{max}$.

Besides for reliable work of the quantum supercapacitor limiting density of a current in it should be limited by value $1.02 \cdot 10^5$ A/cm$^2$, determined from the formula

$$j_e = 12\pi e m_e^3 \alpha^8 c^4 / h^3 = 1{,}02 \cdot 10^5 \, A / cm^2 \, .$$

It is characterised in that the cluster has at least one distinctive cross size, determined in an interval

$$7{,}2517 \text{ nm} \ \le r \le 29{,}0068 \text{ nm},$$

The thickness of the tunnel-transparent gap being not more than 7,2517 nm, the spacing between the electrodes being more than 7,2517 nm.

In the invention limit values are determined from the formula $r = a \cdot r_0$, where $r_0$ determining as ring radius of a electron wave according to the formula $r_0 = \hbar/(m_e \alpha^2 c) = 7.2517$ nm, where $\hbar$ - constant of Plank, $m_e$ - electron mass, $\alpha = 1/137{,}036$ - constant of thin structure, $c$ - speed of light, $a$ - factor determined within the range $1 \le a \le 4$.

In one variant the clusters have centrally symmetric form, in another variant it is extending and have a distinguished cross-sectional size determining in intervals

$$14.5034 \text{nm} \ \le r \le 29.0068 \text{ nm}$$

Extending clusters can place along the axis and have regular structure with the period determined in intervals

$$7{,}2517 \text{пм} \ \le r \le 29{,}0068 \text{ пм}$$

According to another embodiment of invention a plurality of clusters can be regular located at least in one layer, the intervals between clusters being tunnel- transparent not exceeding 7,2517 nm ($r_0$).

Besides a plurality of clusters with tunnel-transparent gaps can be regular located as layers, at least, in one of layers the parameters of clusters can differ from parameters of clusters in the next layers. The intervals between must be tunnel-transparent and not exceeding 7,2517 nm ($r_0$).

The mode of work of the capacitor in a discharge mode is characterized also in that to the capacitor, through loading, a source of a current with sign, which is opposite to sign of a field of the capacitor is connected in a charge mode. It is necessary for completely taking off charges on all depth of the capacitor. Otherwise capacitor is unloaded partially.

In the capacitors the limiting working frequency of management of the quantum supercapacitor achieves the value of

$$f_e^0 = f_e / 2 = m_e (\alpha^2 c)^2 / 2h = 1.752 \cdot 10^{11} H \, .$$

That is especially important for increase of capacitor speed used in memory,

The examples of realization of these devices are given below and are represented on the drawings.

**The list of figures specified on the drawings**

Fig. 1. Nanoelement of quantum supercapacitors

Fig.2. Quantum supercapacitor with dielectric, consisting from central-symmetric clusters.

Fig.3. Quantum supercapacitor with dielectric, consisting from axi-symmetric clusters.

**Brief description of the drawings**

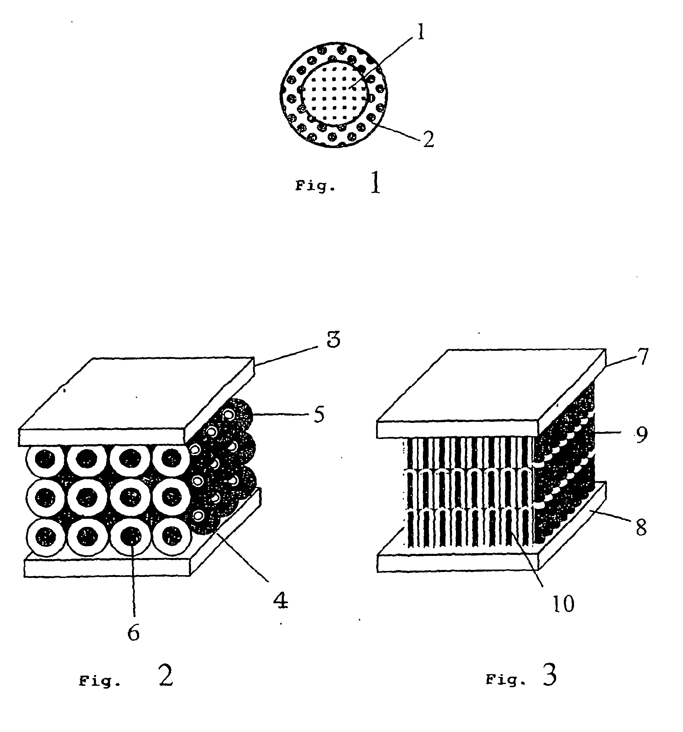

On fig.1 the typical nanoelement of quantum supercapacitors is represented

Here 1 - a central-symmetric cluster, 2 - a tunnel-transparent sheath.

Except for such construction of clusters can be axisymmetric. It is important, that the resonant conditions of formation in them of a ring wave of electron were carried out

On fig.2 is shown one of variants of quantum supercapacitors in accordance with the present invention.

Here 3 and 4 are the conducting electrodes, 5 is the tunnel-transparent sheath of cluster, and 6 is the central-symmetric cavity in cluster. The cluster cavity 6 can be filled by the appropriate material or gas for creation of conditions of formation ring resonant electron. Tunnel-transparent sheath 5 divides cluster among themselves and creates conditions of passage of electrons as a homogeneous wave from the cathode to the anode. The anode and cathode can be interchanged in position, i.e., the condenser is not polar.

On fig.3 another variants of quantum superccapacitors are represented

Here 7 and 8 are the conducting electrodes, 9 is the tunnel-transparent sheath of cluster, and 10 is the axisymmetric cavity in cluster. The cluster cavity 10 can be filled by the appropriate material or gas for creation of conditions of formation ring resonant electron. Tunnel-transparent sheath 9 divides cluster among themselves and creates conditions of passage of electrons as a homogeneous wave from the cathode to the anode. The anode and cathode can be interchanged in position, i.e., the condenser is not polar.

Each layer of capacitor showing on fig.2 and fig.3, should be homogeneous. At the same time layers can differ from each other in cluster sizes or material.

According to the further improvement, the capacitor is characterized also in that the capacitor electrodes are made from conducting materials with various electrical properties. In such case the various works of an electron output from the electrodes allow to change conditions of a charge and discharge of the capacitor. In this case discharge conditions can be bipolar as well as unipolar.

*Embodiment of the invention*

The claimed invention opens a prospect an opportunity of increase of specific density of energy content at simultaneous increase of working temperatures of capacitors and reduction of leakage currents, that increases a storage time of energy in the capacitor. These parameters determine a commercial realizability of capacitors. However, the problem is whether it is possible to use the modern techniques for producing the proposed displays and whether the mass-produced devices are economical.

Let's consider opportunities of technical realization. Let's show, that the creation offered nanostructured materials for capacitors as clusters, divided tunnel-transparent intervals is quite feasible on modern technological base.

Now in an electrotechnical industry are widely used dielectrics with the nonlinear characteristic, on the basis of which the limiters of input voltage - varistors are created. In this elements have place the discharge proceeds without any destruction of a material, for example in wide-gap semiconductors, designed in the form of ZnO multilayer polycrystalline films. The size of crystallites-clusters in these films is 0.2-15.0 $\mu$m. They are divided by $Bi_2O_3$ tunnel-transparent gaps of the thickness 2.0-10.0 nm [10]. Manufacture of varistors is well organized. Based on the manufacture it is possible simply enough to make clusters by the size less than 200 nm, having finished them up to the characteristic size 14.5 nm.

In this case resonant properties of electrons will be shown and the element will get new properties - property of the store of energy.

There are two methods of forming spherical and sphere-like particles [11. The first method - metal or semiconductor clusters of a diameter up to 37 nm are formed of a gas phase with their further oxidation in the oxygen flow or similar chemicals. Formation of such particle is similar to formation of hail in the Earth atmosphere. The second method is the colloidal method. It is based on cluster precipitation from metal salt solutions following by the chemical coating with corresponding enclosures.

Nanosized hollow spheres of zirconium dioxide are automatically obtained during the process of high -frequency plasma-chemical denitrification; therefore they may be applied to the substrate directly from plasma. [12]. Or, for example, 4-15 nm particles result automatically in material $Mo_2N$ [13].

Designing planar vertical nanochannels is based on collective formation methods, e.g. according to electrochemical oxidation Al, Ta, Nb, Hf, etc. The formed channel may be filled with metal or semiconductor by the galvanic technique [14].

Designing planar vertical nanochannels is based on collective formation methods, e.g. according to electrochemical oxidation Al, Ta, Nb, Hf, etc. The formed channel may be filled with metal or semiconductor by the galvanic technique [14].

The aforementioned examples show that the modern techniques allow producing nanostructured materials for the quantum supercapacitor on the basis of existing technologies.

Besides in microelectronics there are fulfilled ways of creation on silicon gigabite memory. It is possible to apply nanostructured material to increase of a storage time and reduction of the sizes of cells of such memory. It can directly be plated on cells of memory from a gas phase through open windows of a mask. In this case it is possible on the same surface of silicon to receive greater volume of memory or its smaller power consumption.

It is especially important, that it is possible to receive non-volatile memory. Thus the minimally possible cells of memory for the perspective integrated circuits will not exceed the size one cluster with an sheath, i.e., about 30 nm.

It is important, that this size is a fundamental limit for the electronic circuits using electrons as carriers. Below than this size to create elements of the integrated circuits it is impossible due to tunnel effects appearing between control lines.

As applied to power engineering for buffer accumulation of a volume energy it is possible to use for creation quantum supercapacitors more simple technology of making of nanostructured material, for example, on the basis of creation nanoporous foam. For this purpose, it is possible to finish technology of creation of carbon foam or technology of synthesis of nanoporous silicate glasses [15]. Besides the low-coast method of synthesis of spherical porous particles on sol-gel method will allow also to generate nanostructured material for the capacitor [16].

Information Sources

1. US Patent 5.856.907
2. US Patent 6.180.252
3. Electrochemistry. Past thirty and next thirty years. G. Bluma. M., World, 1982 (In Russian).
4. US Patents 4.697.224, 5.557.497,
5. Russian Patent №2160940
6. PCT/BY99/00012 «Quantum-Size Electronic Devices and Operating Conditions Thereof» (International Publication Number: WO 00/41247, 13.07.2000)
7. M. Beyer, W. Boeck, K. Moller, W. Zaengl. Hochspannungstechnic. Theoretische und Praktische Grundlagen. Springer-Verlag, 1986.
8. S.M. Sze. Physics of Semiconductor Devices. A Wiley-Interscience Publication John Wiley&Sons. New York... 1981 Buzaneva E.V. Microstructures of integral electronics. M. Radio. 1990.
9. Application PCT WO 98/21754, 22.05.1998.
10. Petrov U.I. Cluster and minor particles. M. Nauka.1986, 368 pp.Dedov N.V. et al., Structural studies of powders on basis of zirconium dioxide produced by HF-plasmachemical denitration method. Glass and Ceramics. 1991. №10, p.17-19.J. Phys. Chem. 18. №15. 1994. P. 4083.
11. Averianov E.E. Anodization manual, M., Mashinostroenie, 1988 US Patent 5.300.272
12. Anal. Sci. 10. № 5. 1994. P. 737.
13. J. Phys. Chem. 18 № 15, 1994, P. 4083.
14. Averjanov E.E. Handbook for anodic treatment. M. Mechanics 1988.
15. US 5,300,272.
16. Anal. Sci. 10. № 5, 1994, P. 737.

**Claims**

1. Using of an electronic device containing at least two electrodes (3, 4, 7, 8), the interval between which is filled by nanostructured materials consisting of clusters (1) with a tunnel-transparent gap (2, 5, 9),
   wherein the cluster's size has cross-section, determined in the range $7{,}2517 \text{ nm} \leq r \leq 29{,}0068 \text{ nm}$,
   wherein the clusters (1) are made in the form of cavities (6, 10) each having a sheath (5, 9) being made as a tunnel-transparent layer, thickness of which being not more than 7,2517 nm, wherein the sheath (5, 9) is made from either semiconductor, or dielectric, or high molecular organic substance,
   wherein the spacing between the electrodes (3, 4, 7, 8) being more than 7,2517 nm,
   wherein an electric field strength on one cluster (1) for work of the capacitor in storage mode does not exceed $1{,}37 \cdot 10^5$ V/cm,
   wherein the maximal field strength in the charge mode does not exceed $4{,}11 \cdot 10^5$ V/cm,
   wherein a working current density through the electronic device does not exceed $1{,}02 \cdot 10^5$ A/cm$^2$,
   **characterized in that** the electronic device is used as a supercapacitor,
   wherein the clusters (1) contact at least in two points of the cavity (6, 10) with next clusters (1), forming thereby a material similar to foam with open pores,

wherein the pores are filled either with a gas, or with a semiconductor, or with a dielectric, having the properties, which are different from the properties of the material of the sheath (5, 9).

2. Using of an electronic device as a supercapacitor according to the claim 1, **characterized in that,** the clusters (1) have centrally symmetric form.

3. Using of an electronic device as a supercapacitor according to the claim 1, **characterized in that** clusters are made extended and have a distinguished cross-sectional size determined within the range 14,5034 nm ≤ r ≤ 29,0068 nm.

4. Using of an electronic device as a supercapacitor according to one of the preceding claims, **characterized in that** the electrodes (3, 4, 7, 8) of the capacitor are made from conducting materials with various electrical properties.

5. Using of an electronic device as a supercapacitor according to one of the preceding claims, **characterized in that** in a discharge mode to the supercapacitor, through a loading, is connected a source of a current with a sign, which is opposite to a sign of a field of the supercapacitor in a charge mode.

**Patentansprüche**

1. Verwendung einer elektronischen Vorrichtung mit wenigstens zwei Elektroden (3, 4, 7, 8), wobei der Zwischenraum zwischen diesen durch nanostrukturierte Materialien gefüllt ist, die aus Clustern (1) mit einer tunneltransparenten Lücke (2, 5, 9) bestehen, wobei die Clustergröße einen Querschnitt hat, der in dem Bereich von 7,2517 nm ≤ r ≤ 29,0068 nm liegt,
wobei die Cluster (1) in Form von Hohlräumen (6, 10) ausgeführt sind, die jeweils eine Hülle (5, 9) aufweisen, die als tunneltransparente Schicht ausgeführt ist, deren Dicke nicht mehr als 7,2517 nm beträgt, wobei die Hülle (5, 9) entweder aus einem Halbleiter, einem Dielektrikum oder einer hochmolekularen organischen Substanz ausgeführt sind,
wobei der Abstand zwischen den Elektroden (3, 4, 7, 8) mehr als 7,2517 nm beträgt,
wobei die Feldstärke an einem Cluster (1) bei einer Arbeit des Kondensators im Speichermodus $1,37 \cdot 10^5$ V/cm nicht überschreitet,
wobei die maximale Feldstärke im Lademodus $4,11 \cdot 10^5$ V/cm nicht überschreitet, und
wobei eine Arbeitsstromdichte durch die elektronische Vorrichtung $1,02 \cdot 10^5$ A/cm$^2$ nicht überschreitet,
**dadurch gekennzeichnet, dass** die elektronische Vorrichtung als Superkondensator verwendet wird,
wobei die Cluster (1) an wenigstens zwei Punkten des Hohlraums (6, 10) mit nächsten Clustern (1) in Berührung stehen, wodurch ein Material gebildet wird, das einem Schaum mit offenen Poren ähnlich ist, und
wobei die Poren entweder mit einem Gas oder mit einem Halbleiter oder mit einem Dielektrikum gefüllt sind, das Eigenschaften aufweist, die sich von den Eigenschaften des Materials der Hülle (5, 9) unterscheiden.

2. Verwendung einer elektronischen Vorrichtung als Superkondensator nach Anspruch 1, **dadurch gekennzeichnet, dass** die Cluster (1) eine zentral symmetrische Form aufweisen.

3. Verwendung einer elektronischen Vorrichtung als Superkondensator nach Anspruch 1, **dadurch gekennzeichnet, dass** die Cluster verlängert ausgeführt sind und eine unterschiedliche Querschnittsgröße aufweisen, die innerhalb eines Bereichs von 14,5034 nm ≤ r ≤ 29,0068 nm liegt.

4. Verwendung einer elektronischen Vorrichtung als Superkondensator nach einem der vorhergehenden Ansprüche, **dadurch gekennzeichnet, dass** die Elektroden (3, 4, 7, 8) des Kondensators aus leitenden Materialien mit verschiedenen elektrischen Eigenschaften ausgeführt sind.

5. Verwendung einer elektronischen Vorrichtung als Superkondensator nach einem der vorhergehenden Ansprüche, **dadurch gekennzeichnet, dass** in einem Entlademodus mit dem Superkondensator über eine Last eine Stromquelle mit einem Vorzeichen verbunden ist, die einem Vorzeichen eines Feldes des Superkondensators in einem Lademodus entgegengesetzt ist.

**Revendications**

1. Utilisation d'un dispositif électronique contenant au moins deux électrodes (3, 4, 7, 8) dont l'intervalle entre les deux est rempli de matériaux nanostructurés consistant en des agrégats (1) possédant un écart transparent à l'effet tunnel (2, 5, 9),

dans lequel la dimension d'un agrégat a une section transversale déterminée de l'ordre de 7,2517 nm ≤ r ≤ 29,0068 nm,

dans lequel les agrégats (1) sont réalisés de manière à avoir la forme de cavités (6, 10) pourvues chacune d'une gaine (5, 9) formée en tant que couche transparente à l'effet tunnel dont l'épaisseur ne dépasse pas 7,2517 nm, dans lequel la gaine (5, 9) est formée soit d'un semi-conducteur, soit d'un diélectrique, soit d'une substance organique de masse moléculaire élevée,

dans lequel la distance entre les électrodes (3, 4, 7, 8) est supérieure à 7,2517 nm,

dans lequel la force d'un champ électrique sur un agrégat (1) pour un fonctionnement du condensateur en mode de mémorisation ne dépasse pas $1{,}37 \cdot 10^5$ V/cm,

dans lequel la force de champ maximale dans le mode de charge ne dépasse pas $4{,}11 \cdot 10^5$ V/cm,

dans lequel une densité de courant de fonctionnement à travers le dispositif électronique ne dépasse pas $1{,}02 \cdot 10^5$ A/cm$^2$,

**caractérisée en ce que** le dispositif électronique est utilisé en tant que supercondensateur,

dans lequel les agrégats (1) sont en contact au moins en deux points de la cavité (6, 10) avec des agrégats suivants (1), formant ainsi un matériau similaire à une mousse à pores ouverts,

dans lequel les pores sont remplis soit d'un gaz, soit d'un semi-conducteur, soit d'un diélectrique dont les propriétés sont différentes des propriétés du matériau de la gaine (5, 9).

2. Utilisation d'un dispositif électronique en tant que supercondensateur selon la revendication 1, **caractérisée en ce que** les agrégats (1) ont une forme centralement symétrique.

3. Utilisation d'un dispositif électronique en tant que supercondensateur selon la revendication 1, **caractérisée en ce que** les agrégats sont réalisés allongés et ont une dimension de section transversale distincte déterminée entre 14,5034 nm ≤ r ≤ 29,0068 nm.

4. Utilisation d'un dispositif électronique en tant que supercondensateur selon l'une des revendications précédentes, **caractérisée en ce que** les électrodes (3, 4, 7, 8) du condensateur sont formées de matériaux conducteurs possédant diverses propriétés électriques.

5. Utilisation d'un dispositif électronique en tant que supercondensateur selon l'une des revendications précédentes, **caractérisée en ce que,** dans un mode de décharge, une source de courant de signe opposé à un signe d'un champ du supercondensateur dans un mode de charge est connectée au supercondensateur par le biais d'une charge.

Fig. 1

Fig. 2

Fig. 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 5856907 B
- US 6180252 B
- US 4697224 A
- US 5557497 A
- RU 2160940

- BY 9900012 W
- WO 0041247 A
- WO 9821754 A
- US 5300272 A

### Non-patent literature cited in the description

- **G. BLUMA. M.** *World,* 1982
- **M. BEYER ; W. BOECK ; K. MOLLER ; W. ZA-ENGL.** Hochspannungstechnic. Theoretische und Praktische Grundlagen. Springer-Verlag, 1986
- **S.M. SZE.** Physics of Semiconductor Devices. A Wiley-Interscience Publication John Wiley&Sons, 1981
- **M. RADIO.** *Microstructures of integral electronics,* 1990
- **PETROV U.I.** *Cluster and minor particles. M. Nauka.,* 1986, 368

- **DEDOV N.V. et al.** Structural studies of powders on basis of zirconium dioxide produced by HF-plasmachemical denitration method. *Glass and Ceramics.,* 1991, 17-19
- *J. Phys. Chem.,* 1994, vol. 18 (15), 4083
- **AVERIANOV E.E.** Anodization manual, M., Mashinostroenie. 1988
- *Anal. Sci.,* 1994, vol. 10 (5), 737
- **AVERJANOV E.E.** Handbook for anodic treatment. M. Mechanics. 1988